# EUROPÄISCHE PATENTANMELDUNG

(11) **EP 1 204 245 A2**
(43) Veröffentlichungstag der Anmeldung: **08.05.2002**
(21) Anmeldenummer: 01124154.4
(22) Anmeldetag: 10.10.2001
(51) Int. Cl.: H04L 12/28, H04L 12/56, H04L 1/18

(54) **Drathloses Netzwerk mit einem Datenaustausch nach der Automatic Retransmission Query (ARQ) -Methode**

(30) Priorität: 11.10.2000 DE 10050117
(71) Anmelder: Philips Corporate Intellectual Property GmbH, 52064 Aachen (DE); Koninklijke Philips Electronics N.V., 5621 BA Eindhoven (NL)
(72) Erfinder: Herrmann, Christoph, Dr., 52064 Aachen (DE)
(74) Vertreter: Volmer, Georg, Dipl.-Ing.

(57) **Zusammenfassung**

Die Erfindung bezieht sich auf ein drahtloses Netzwerk mit einer Funknetzwerk-Steuerung und mehreren zugeordneten Terminals, die jeweils zum Austausch von Daten nach der hybriden ARQ-Methode vom Typ II oder III vorgesehen sind und die jeweils eine Empfangs- und/oder Sendeseite bilden. Eine physikalische Schicht einer Sendeseite ist
- zur Speicherung von codierten Transportblöcken in einem Speicher, die wenigstens eine von der zugeordneten Funkverbindungssteuerungs-Schicht gelieferten Paketeinheit enthalten und die durch eine Paketeinheits-Folgenummer identifizierbar ist,
- zur Speicherung von Kurz-Folgenummern, deren Länge von der maximalen Anzahl von zu speichernden codierten Transportblöcken abhängt und die eindeutig auf eine Paketeinheits-Folgenummer abbildbar sind, und
- zur Übertragung von codierten Transportblöcken wenigstens mit der zugeordneten Kurz-Folgenummer vorgesehen.

Eine physikalische Schicht einer Empfangsseite ist zur Prüfung des korrekten Empfangs des codierten Transportblocks und zur Sendung eines positiven Bestätigungsbefehls bei korrektem Empfang und zur Sendung eines negativen Bestätigungsbefehls zur Sendeseite bei fehlerbehafteten Empfang über einen Rückkanal vorgesehen.

## Beschreibung

Die Erfindung bezieht sich auf ein drahtloses Netzwerk mit einer Funknetzwerk-Steuerung und mehreren zugeordneten Terminals, die jeweils zum Austausch von Daten vorgesehen sind und die jeweils eine Empfangs- und/oder Sendeseite bilden.

Ein solches drahtloses Netzwerk ist aus dem Dokument "3^{rd} Generation Partnership Project; Technical Specification Group Radio Access Network; Report on Hybrid ARQ Type II/III (Release 2000), 3G TR 25.835 V0.0.2, TSG-RAN Working Group 2 (Radio L2 and Radio L3), Sophia Antipolis, France, 21-15 August 2000" bekannt. Hier wird zur gesicherten Übertragung von Daten eine Methode verwendet, die hybride ARQ-Methode Typ II oder III (ARQ = Automatic Repeat Request/ automatische Wiederholungsrückfrage) genannt wird. Die in Paketeinheiten (PDU = Packet Data Unit) von der Funkverbindungssteuerungs-Schicht (RLC-Schicht) gesendeten Daten sind zusätzlich zur fehlerkorrigierenden Codierung mit einer Fehlerkontrolle durch Übertragungswiederholung versehen. Das bedeutet, dass bei fehlerhaftem Empfang einer in einer von der zugeordneten physikalischen Schicht codierten Transportblock verpackten Paketeinheit ein erneutes Versenden der fehlerhaft empfangenen Paketeinheit erfolgt. Bei der hybriden ARQ-Methode Typ I wird die fehlerhaft empfangene Paketeinheit verworfen und eine identische Kopie erneut angefordert. Bei den hybriden ARQ-Methoden Typ II und III wird die fehlerhaft empfangene Paketeinheit zwischengespeichert und nach dem Empfang zusätzlicher auf die empfangene Paketeinheit bezogener inkrementeller Redundanz zusammen mit der fehlerhaft empfangenen Paketeinheit decodiert. Weil nur inkrementelle Redundanz und nicht die gesamte fehlerhafte Paketeinheit erneut übertragen wird, verringert sich die Datenmenge, die für Übertagungswiederholungen anfällt. Bei der ARQ-Methode Typ II ist die inkrementelle Redundanz ohne das zwischengespeicherte (fehlerhafte) Paket nutzlos, bei ARQ-Methode Typ III, ist die inkrementelle Redundanz auch ohne das zwischengespeicherte (fehlerhafte) Paket decodierbar. Die codierten Transportblöcke werden über wenigstens einen Transportkanal gesendet. Eine Meldung über den fehlerfreien Empfang erfolgt in oben genannten Dokument erst dann, wenn die empfangende RLC-Schicht an Hand von sogenannten RLC-Folgenummern feststellt, dass ihm Paketeinheiten fehlen, selbst wenn die physikalische Schicht die Paketeinheit schon als fehlerhaft erkannt hat. Das bedeutet, dass eine Paketeinheit über lange Zeiträume zwischengespeichert werden muss, bis eine inkrementelle Redundanz angefordert wird und dann nach erfolgreicher Decodierung der Empfang als korrekt bestätigt werden kann, insbesondere dann wenn die empfangende Seite die Netzseite ist, die physikalische Schicht und die RLC-Schicht in der Regel auf unterschiedlichen Hardwarekomponenten angesiedelt sind. Zusätzlich zu den in den Transportblöcken enthaltenen Paketeinheiten müssen für die Anwendung der hybriden ARQ-Methoden vom Typ II oder III synchron mit dem codierten Transportblock die RLC-Folgenummer der Paketeinheit und eine Redundanzversion übertragen werden. Dies geschieht in der Regel über einen deutlich besser geschützten Transportkanal, um sicherzustellen, dass diese Information schon beim ersten Empfang fehlerfrei ist. Sie ist entscheidend, wenn nach einer Übertragungswiederholung mit inkrementeller Redundanz die zwischengespeicherte (fehlerhafte) Paketeinheit zusammen mit der inkrementellen Redundanz decodiert werden soll, da die inkrementelle Redundanz über die Redundanzversion der jeweiligen Paketeinheit zugeordnet werden muss.

Der Erfindung liegt die Aufgabe zugrunde, ein drahtloses Netzwerk zu schaffen, bei dem fehlerbehaftete nach der ARQ-Methode vom Typ II oder III wiederholt zu übertragende Daten im Mittel geringere Zeit zwischengespeichert werden.

Die Aufgabe wird durch das eingangs genannte drahtlose Netzwerk, das eine Funknetzwerk-Steuerung und mehrere zugeordnete Terminals enthält, die jeweils zum Austausch von Daten vorgesehen sind und die jeweils eine Empfangs- und/oder Sendeseite bilden, durch folgende Merkmale gelöst:
Eine physikalische Schicht einer Sendeseite ist
- zur Speicherung von codierten Transportblöcken in einem Speicher, die wenigstens eine von der zugeordneten Funkverbindungssteuerungs-Schicht gelieferten Paketeinheit enthalten und die durch eine Paketeinheits-Folgenummer identifizierbar ist,
- zur Speicherung von Kurz-Folgenummern, deren Länge von der maximalen Anzahl von zu speichernden codierten Transportblöcken abhängt und die eindeutig auf eine Paketeinheits-Folgenummer abbildbar sind, und
- zur Übertragung von codierten Transportblöcken wenigstens mit der zugeordneten Kurz-Folgenummer und
eine physikalische Schicht einer Empfangsseite ist zur Prüfung des korrekten Empfangs des codierten Transportblocks und zur Sendung eines positiven Bestätigungsbefehls bei korrektem Empfang und zur Sendung eines negativen Bestätigungsbefehls zur Sendeseite bei fehlerbehafteten Empfang über einen Rückkanal vorgesehen.

Das erfindungsgemäße drahtlose Netzwerk kann beispielsweise ein Funknetzwerk nach dem UMTS-Standard (UMTS = Universal Mobile Telecommunication System) sein. Hierbei wird durch die Übertragung eines Bestätigungsbefehls über einen bisher nicht bekannten Rückkanal direkt zwischen einer physikalischen Schicht einer Sendeseite (z.B. Funknetzwerk-Steuerung) und der physikalischen Schicht einer Empfangsseite (z.B. Terminal) bei der Übertragung beispielsweise von Daten nach der ARQ-Methode vom Typ II oder III eine korrekte oder fehlerbehaftete Übertragung eines Transportblocks schneller der Sendeseite mitgeteilt als bisher bekannt ist. Dadurch kann eine Übertragungswiederholung mit inkrementeller Redundanz schnell erfolgen. Das erlaubt der Empfangsseite, den fehlerhaft empfangenen codierten Transportblock deutlich kürzer zwischenzuspeichern, da die für die korrekte Decodierung erforderliche zusätzliche Redundanz früher vorliegt. Somit reduziert sich auch der im Mittel erforderliche Speicherbedarf bzw. Speicherbereich zur Zwischenspeicherung von fehlerhaft empfangenen codierten Transportblöcken.

Die Verwendung der Kurz-Folgenummern reduziert die Größe der zur Verwaltung der Transportblöcke und Paketeinheiten erforderlichen zusätzlich zu übertragenden Information und vereinfacht die Zuordnung eines empfangenen Bestätigungsbefehls zu den gespeicherten Transportblöcken. Hierbei ist die physikalische Schicht einer Empfangsseite zur Sendung eines positiven oder negativen Bestätigungsbefehls mit der Kurz-Folgenummer des korrekt oder fehlerhaft empfangenen Transportblocks über den Rückkanal vorgesehen.

Anstelle der Übertragung der Kurz-Folgenummer kann eine Kurz-Folgenummer eines Transportblocks, auf den sich ein empfangener Bestätigungsbefehl bezieht, auch implizit anhand der Zeitdauer zwischen Übertragung des Transportblocks und Empfang des Bestätigungsbefehls und der Sendereihenfolge des Bestätigungsbefehls bei mehreren empfangenen Bestätigungsbefehlen ermittelt werden. Dies wird auf einfache Weise dadurch ermöglicht, dass eine Übertragung der Transportblöcke in Funkrahmen vorgesehen ist und dass die Übertragung eines Bestätigungsbefehls von der Sendeseite zur Empfangsseite frühestens im F-ten Funkrahmen nach dem Funkrahmen vorgesehen ist, der den entsprechenden Transportblock enthält (mit F≥1). Dabei entspricht die Reihenfolge mehrerer Bestätigungsbefehle der Reihenfolge der Übertragung von Transportblöcken in einem vorhergehenden Funkrahmen.

Wenn die physikalische Schicht einer Sendeseite einen negativen Bestätigungsbefehl erhalten hat, fordert die physikalische Schicht bei der Funkverbindungssteuerungs-Schicht diejenige Paketeinheit noch einmal an, die über den codierten Transportblock fehlerbehaftet übertragen worden ist. Nach Empfang einer Paketeinheit bildet die physikalische Schicht daraus einen codierten Transportblock, der eine inkrementelle Redundanz enthält.

Die Erfindung bezieht sich auch auf eine Funknetzwerk-Steuerung und ein Terminal in einem drahtlosen Netzwerk, die jeweils Daten nach der hybriden ARQ-Methode austauschen.

Ausführungsbeispiele der Erfindung werden nachstehend anhand der Fig. näher erläutert.
Es zeigen:
- Fig. 1: ein drahtloses Netzwerk mit einer Funknetzwerk-Steuerung und mehreren Terminals,
- Fig. 2: ein Schichtenmodell zur Erläuterung verschiedener Funktionen eines Terminals oder einer Funknetzwerk-Steuerung und
- Fig. 3: mehrere Funkrahmen, in denen über den Funkweg zu übertragende Daten zwischen Funknetzwerk-Steuerung und Terminals enthalten sind.

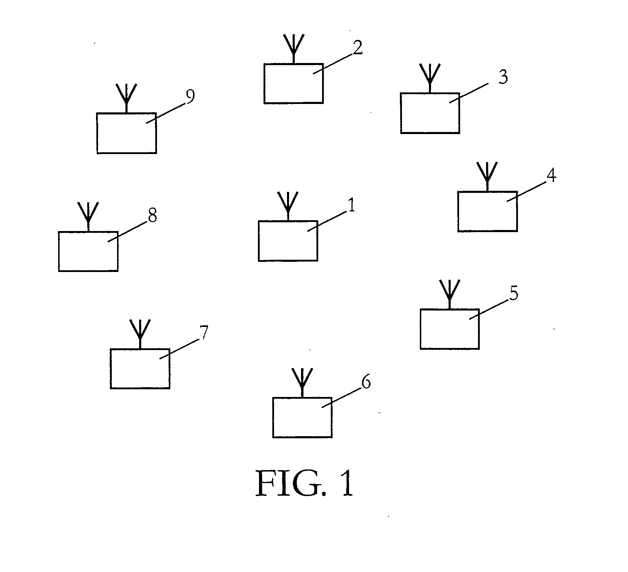

In Fig. 1 ist ein drahtloses Netzwerk, z.B. Funknetzwerk, mit einer Funknetzwerk-Steuerung (Radio Network Controller = RNC) 1 und mehreren Terminals 2 bis 9 dargestellt. Die Funknetzwerk-Steuerung 1 ist für Steuerung aller am Funkverkehr beteiligten Komponenten verantwortlich, wie z.B. der Terminals 2 bis 9. Ein Steuer- und Nutzdatenaustausch findet zumindest zwischen der Funknetzwerk-Steuerung 1 und den Terminals 2 bis 9 statt. Die Funknetzwerk-Steuerung 1 baut jeweils eine Verbindung zur Übertragung von Nutzdaten auf.

In der Regel sind die Terminals 2 bis 9 Mobilstationen und die Funknetzwerk-Steuerung 1 ist fest installiert. Eine Funknetzwerk-Steuerung 1 kann gegebenenfalls aber auch beweglich bzw. mobil sein.

In dem drahtlosen Netzwerk werden beispielsweise Funksignale nach dem FDMA-, TDMA- oder CDMA-Verfahren (FDMA = frequency division multiplex access, TDMA = time division multiplex access, CDMA = code division multiplex access) oder nach einer Kombination der Verfahren übertragen.

Beim CDMA-Verfahren, das ein spezielles Code-Spreiz-Verfahren (code spreading) ist, wird eine von einem Anwender stammende Binärinformation (Datensignal) mit jeweils einer unterschiedlichen Codesequenz moduliert. Eine solche Codesequenz besteht aus einem pseudo-zufälligen Rechtecksignal (pseudo noise code), dessen Rate, auch Chiprate genannt, in der Regel wesentlich höher als die der Binärinformation ist. Die Dauer eines Rechteckimpulses des pseudo-zufälligen Rechtecksignals wird als Chipintervall T_{c} bezeichnet. 1/T_{c} ist die Chiprate. Die Multiplikation bzw. Modulation des Datensignals mit dem pseudo-zufälligen Rechtecksignal hat eine Spreizung des Spektrums um den Spreizungsfaktor N_{c} = T/T_{c} zur Folge, wobei T die Dauer eines Rechteckimpulses des Datensignals ist.

Nutzdaten und Steuerdaten zwischen wenigstens einem Terminal (2 bis 9) und der Funknetzwerk-Steuerung 1 werden über von der Funknetzwerk-Steuerung 1 vorgegebene Kanäle übertragen. Ein Kanal ist durch einen Frequenzbereich, einen Zeitbereich und z.B. beim CDMA-Verfahren durch einen Spreizungscode bestimmt. Die Funkverbindung von der Funknetzwerk-Steuerung 1 zu den Terminals 2 bis 9 wird als Downlink und von den Terminals zur Basisstation als Uplink bezeichnet. Somit werden über Downlink-Kanäle Daten von der Basisstation zu den Terminals und über Uplink-Kanäle Daten von Terminals zur Basisstation gesendet.

Beispielsweise kann ein Downlink-Steuerkanal vorgesehen sein, der benutzt wird, um von der Funknetzwerk-Steuerung 1 Steuerdaten vor einem Verbindungsaufbau an alle Terminals 2 bis 9 zu verteilen. Ein solcher Kanal wird als Downlink-Verteil-Steuerkanal (broadcast control channel) bezeichnet. Zur Übertragung von Steuerdaten vor einem Verbindungsaufbau von einem Terminal 2 bis 9 zur Funknetzwerk-Steuerung 1 kann beispielsweise ein von der Funknetzwerk-Steuerung 1 zugewiesener Uplink-Steuerkanal verwendet werden, auf den aber auch andere Terminals 2 bis 9 zugreifen können. Ein Uplink-Kanal, der von mehreren oder allen Terminals 2 bis 9 benutzt werden kann, wird als gemeinsamer Uplink-Kanal (common uplink channel) bezeichnet. Nach einem Verbindungsaufbau z.B. zwischen einem Terminal 2 bis 9 und der Funknetzwerk-Steuerung 1 werden Nutzdaten über einen Downlink- und ein Uplink-Nutzkanal übertragen. Kanäle, die nur zwischen einem Sender und einem Empfänger aufgebaut werden, werden als dedizierte Kanäle bezeichnet. In der Regel ist ein Nutzkanal ein dedizierter Kanal, der von einem dedizierten Steuerkanal zur Übertragung von verbindungsspezifischen Steuerdaten begleitet werden kann.

Damit Nutzdaten zwischen der Funknetzwerk-Steuerung 1 und einem Terminal ausgetauscht werden können, ist es erforderlich, dass ein Terminal 2 bis 9 mit der Funknetzwerk-Steuerung 1 synchronisiert wird. Beispielsweise ist aus dem GSM-System (GSM = Global System for Mobile communication) bekannt, in welchem eine Kombination aus FDMA- und TDMA-Verfahren benutzt wird, dass nach der Bestimmung eines geeigneten Frequenzbereichs anhand vorgegebener Parameter die zeitliche Position eines Rahmens bestimmt wird (Rahmensynchronisation), mit dessen Hilfe die zeitliche Abfolge zur Übertragung von Daten erfolgt. Ein solcher Rahmen ist immer für die Datensynchronisation von Terminals und Basisstation bei TDMA-, FDMA- und CDMA-Verfahren notwendig. Ein solcher Rahmen kann verschiedene Unter- oder Subrahmen enthalten oder mit mehreren anderen aufeinanderfolgenden Rahmen einen Superrahmen bilden.

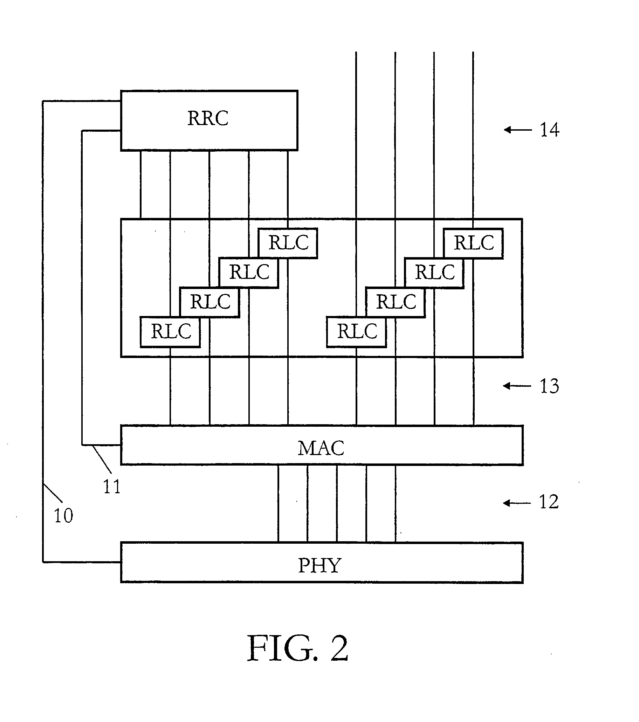

Der Steuer- und Nutzdatenaustausch über die Funkschnittstelle zwischen der Funknetzwerk-Steuerung 1 und den Terminals 2 bis 9 kann mit dem in Fig. 2 dargestellten, beispielhaften Schichtenmodell oder Protokollarchitektur (vgl. z.B. 3^{rd} Generation Partnership Project (3GPP); Technical Specification Group (TSG) RAN; Working Group 2 (WG2); Radio Interface Protocol Architecture; TS 25.301 V3.2.0 (1999-10)) erläutert werden. Das Schichtenmodell besteht aus drei Protokollschichten: der physikalischen Schicht PHY, der Datenverbindungsschicht mit den Unterschichten MAC und RLC (in Fig. 2 sind mehrere Ausprägungen der Unterschicht RLC dargestellt) und der Schicht RRC. Die Unterschicht MAC ist für die Medienzugriffssteuerung (Medium Access Control), die Unterschicht RLC für die Funkverbindungssteuerung (Radio Link Control) und die Schicht RRC für die Funkverwaltungssteuerung (Radio Resource Control) zuständig. Die Schicht RRC ist für die Signalisierung zwischen den Terminals 2 bis 9 und der Funknetzwerk-Steuerung 1 verantwortlich. Die Unterschicht RLC dient zur Steuerung einer Funkverbindung zwischen einem Terminal 2 bis 9 und der Funknetzwerk-Steuerung 1. Die Schicht RRC steuert die Schichten MAC und PHY über Steuerungsverbindungen 10 und 11. Hiermit kann die Schicht RRC die Konfiguration der Schichten MAC und PHY steuern. Die physikalische Schicht PHY bietet der MAC-Schicht Transportkanäle bzw. Transportverbindungen 12 an. Die MAC-Schicht stellt der RLC-Schicht logische Verbindungen 13 zur Verfügung. Die RLC-Schicht ist über Zugangspunkte 14 von Applikationen erreichbar.

In einem solchen Netzwerk wird eine Methode zur sicheren Übertragung von Daten verwendet, die hybride ARQ-Methode (ARQ = Automatic Repeat Request/ automatische Wiederholungsrückfrage) genannt wird. Die in Paketeinheiten (PDU = Packet Data Unit) gesendeten Daten sind zusätzlich zur fehlerkorrigierenden Codierung (Forward Error Correction) mit einer Fehlerkontrolle durch Übertragungswiederholungen versehen. Das bedeutet, dass bei einem fehlerhaften Empfang einer Paketeinheit ein erneutes Versenden der fehlerhaft empfangenen Paketeinheit erfolgt. Bei den hybriden ARQ-Methoden vom Typ II oder III ist es möglich, dass nur bestimmte Teile der Daten bei einer fehlerhaften Übertragung wiederholt gesendet werden. Dies wird auch als inkrementelle Redundanz (Incremental Redundancy) bezeichnet.

Die Paketeinheiten werden in der RLC-Schicht gebildet und in der MAC-Schicht in Transportblöcke verpackt, die über die von der physikalischen Schicht zur Verfügung gestellten Transportkanäle von der Funknetzwerk-Steuerung zu einem Terminal oder umgekehrt übertragen werden. In der physikalischen Schicht werden die Transportblöcke mit einer zyklische Redundanzprüfungsbitfolge (CRC = Cyclic Redundancy Check) versehen und beides zusammen codiert. Das Ergebnis dieser Operation wird als codierter Transportblock bezeichnet. Die codierten Transportblöcke enthalten eine Paketeinheit und Steuerinformationen.

Codierte Transportblöcke, die fehlerhaft übertragen wurden, werden zur Umsetzung der hybriden ARQ-Methode vom Typ II oder III in der physikalischen Schicht der Empfangsseite so lange zwischengespeichert, bis die nachträglich angeforderte inkrementelle Redundanz eine fehlerfreie Decodierung ermöglicht. Bekannt ist, dass dazu als sogenannte Seiteninformation (side information) (vgl. "3^{rd} Generation Partnership Project; Technical Specification Group Radio Access Network; Report on Hybrid ARQType II/III (Release 2000), 3G TR 25.835 V0.0.2, TSG-RAN Working Group 2 (Radio L2 and Radio L3), Sophia Antipolis, France, 21-15 August 2000") wenigstens die RLC-Folgenummer oder Paketeinheits-Folgenummer, welche eine Paketeinheit kennzeichnet, und eine Redundanzversion parallel zum codierten Transportblock bzw. der nachträglich angeforderten inkrementellen Redundanz übertragen werden muss, damit die Empfangsseite bei Empfang eines fehlerhaften codierten Transportblockes bzw. zusätzlicher inkrementeller Redundanz erkennen kann, um welchen codierten Transportblock es sich handelt bzw. auf welchen zwischengespeicherten codierten Transportblock sich die zusätzlich übertragene Redundanz bezieht. Die Redundanzversion gibt an, ob es sich um eine erstmals gesendete inkrementelle Redundanz oder um welche nachfolgend unter Umständen mehrfach wiederholte inkrementelle Redundanz es sich handelt.

Erfindungsgemäß wird bei der Übertragung der Seiteninformation über die Funkschnittstelle anstelle der RLC-Folgenummer eine Kurz-Folgenummer verwendet, deren Länge deutlich kleiner als die RLC-Folgenummer ist. Diese Kurz -Folgenummer ist bestimmt durch die Anzahl M von codierten Transportblöcken, die empfangsseitig maximal gleichzeitig zwischengespeichert werden können, und besteht aus 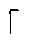 1d M 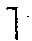 Bits. ( 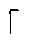 1d M 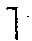 bedeutet den auf die nächst größere natürliche Zahl aufgerundeten Logarithmus dualis) Dazu erzeugt die sendende physikalische Schicht aus der von der RLC-Schicht als Seiteninformation lokal empfangenen RLC-Folgenummer eine Kurz-Folgenummer. Die physikalische Schicht enthält noch eine Tabelle oder einen Speicher, welche die Kurz-Folgenummer und die RLC-Folgenummer so speichert, dass eine Abbildung der RLC-Folgenummer auf die Kurz-Folgenummer erfolgt. Empfängt die physikalische Schicht von der RLC-Schicht einen Transportblock mit Seiteninformation, aber alle Kurz-Folgenummern sind schon vergeben, so kann dieser Transportblock nicht übertragen werden, und die RLC-Schicht muss über diese Stausituation informiert werden. Im anderen Fall wählt die physikalische Schicht eine nicht vergebene Kurz-Folgenummer aus, trägt den Zusammenhang zur RLC-Folgenummer in die Tabelle ein, und codiert den Transportblock und sendet ihn als codierten Transportblock mit der Seiteninformation über die Funkschnittstelle. Für eine nachträglich zu sendende inkrementelle Redundanz, die sich auf diesen codierten Transportblock bezieht, wird wiederum diese Kurz-Folgenummer aus der Tabelle entnommen und in der Seiteninformation parallel mit der inkrementellen Redundanz versendet.

Um der Sendeseite (sendendes Terminal oder Funknetzwerk-Steuerung) mitzuteilen, dass ein Transportblock nicht fehlerfrei übertragen worden ist, ist erfindungsgemäß ein schneller Rückkanal (Back Channel) vorgesehen, der direkt zwischen der empfangenden physikalischen Schicht und der sendenden physikalischen Schicht aufgebaut wird und nicht zwischen den beteiligten RLC-Schichten. Der Rückkanal wird jeweils dann aufgebaut, wenn zwischen einem Terminal und der Funknetzwerk-Steuerung vereinbart worden ist, Daten nach der hybriden ARQ-Methode vom Typ II oder III zu übertragen. Die empfangende physikalische Schicht prüft, ob der codierte Transportblock korrekt übertragen worden ist. Ist dies der Fall wird über den Rückkanal zur sendenden physikalischen Schicht ein positiver Bestätigungsbefehl ACK (Acknowledge) gesendet. Im umgekehrten Fall, wenn der codierte Transportblock nicht fehlerfrei empfangen worden ist, wird ein negativer Bestätigungsbefehl NACK (Negative Acknowledge) zur sendenden physikalischen Schicht geliefert.

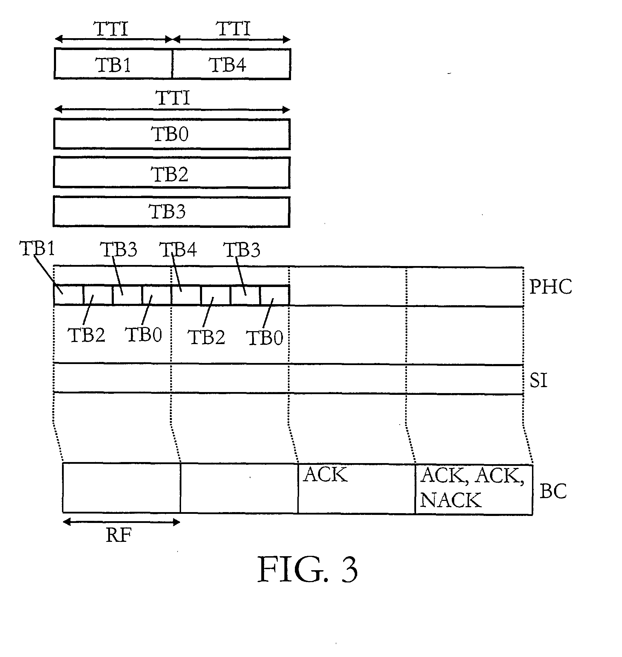

Der positive und negative Bestätigungsbefehl ACK und NACK können jeweils die Kurz-Folgenummer des korrekt oder fehlerhaft empfangenen codierten Transportblocks enthalten. Die sendende Seite kann auch anhand der Nummer eines Funkrahmens, welcher den positiven oder negativen Bestätigungsbefehl enthält, den fehlerhaft übertragenen Transportblock identifizieren. Dabei beziehen sich die Bestätigungsbefehle in einem Funkrahmen des Rückkanals, auf codierte Transportblöcke, die in Übertragungszeitintervallen (TTI = Transmission Time Interval) übertragen wurden, die in einem Funkrahmen zu Ende gingen, der genau F Funkrahmen (mit F≥1) vor dem die Bestätigungsbefehle enthaltenden Funkrahmen lag. Aus der Fig. 3 lässt sich das entnehmen. Ein Transportzeitintervall TTI gibt die Zeitdauer eines Transportblocks an und entspricht mindestens der Dauer eines Funkrahmens RF, der den zeitlichen Verlauf der Übertragung der Transportblöcke über den Funkweg bzw. Funkschnittstelle bestimmt. Die Nummern der Funkrahmen wird in der Regel über einen Verteilkanal (Broadcast channel) den Mobilstationen mitgeteilt. In Fig. 3 sind verschiedene Transportblöcke TB0 bis TB4 dargestellt, die während der Dauer von zwei Funkrahmen RF übertragen werden sollen. Der Transportblock TB0 wird in diesem Beispiel nicht nach der hybriden ARQ-Methode vom Typ II oder III übertragen, während die anderen Transportblöcke nach den hybriden ARQ-Methoden vom Typ II oder III übertragen werden sollen. Die Mitteilung über eine korrekte oder fehlerbehaftece Übertragung erfolgt also nur für die Transportblöcke TB1 bis TB4 mit Hilfe eines positiven oder negativen Bestätigungsbefehls über den physikalischen Rückkanal.

Das Übertragungszeitintervall TTI der Transportblöcke TB1 und TB4 ist gleich der Dauer eines einzigen Funkrahmens RF und das der Transportblöcke TB0, TB2 und TB3 jeweils zwei Funkrahmen RF. Ein erster Teil der Transportblöcke TB2, TB3 und TB0 und der Transportblock TB1 werden während eines ersten Funkrahmens RF und der zweite Teil der Transportblöcke TB2, TB3 und TB0 und der Transportblock TB4 während eines zweiten, darauffolgenden Funkrahmens RF über den physikalischen Kanal PHC zur Übertragung der codierten Transportblöcke verwendet. Es sei vorausgesetzt, dass die Transportblöcke TB1, TB2 und TB4 korrekt und der Transportblock TB3 fehlerbehaftet von einem Terminal oder der Funknetzwerk-Steuerung empfangen worden sind. Der korrekte oder fehlerbehaftete Empfang wird in dem Funkrahmen RF geprüft, der auf das beendete Übertragungszeitintervall (TTI) folgt, und im nächsten Funkrahmen RF über den Rückkanal BC der sendenden Seite mitgeteilt (F=2). Die Fig. 3 zeigt im dritten Funkrahmen RF den positiven Bestätigungsbefehl ACK für den Transportblock TB 1 und im vierten Funkrahmen RF den positiven Bestätigungsbefehl ACK für die Transportblöcke TB4 und TB2 und den negativen Bestätigungsbefehl NACK für den Transportblock TB3. Für den Transportblock TB0 wird kein Bestätigungsbefehl gesendet, da dieser nicht nach einer ARQ-Methode vom Typ II oder III übertragen worden ist. Die Bestätigungsbefehle sind dabei entsprechend der Reihenfolge sortiert, in der die Transportblöcke gesendet worden sind. Der Bestätigungsbefehl kann aber auch während eines späteren Funkrahmens RF gesendet werden. Die Anzahl F der Funkrahmen RF, die zwischen dem Empfang eines Transportblocks (d.h. nach Ablauf des Übertragungszeitintervalls) oder einer Anzahl von Transportblöcken (d.h. nach Ablauf ihrer Übertragungszeitintervalle, die alle an derselben Rahmengrenze enden) und der Sendung eines Bestätigungsbefehls liegen, sollte dabei so gewählt werden, dass die Empfangsseite genügend Zeit hat alle mitgesendeten Transportblöcke zu decodieren und auf Fehlerfreiheit zu untersuchen.

Die Übertragung der Transportblöcke TB0 bis TB4 wird von als Seiteninformationen (Side Information) genannten Daten begleitet, die wenigstens Auskunft über die Redundanzversion und über die Kurz-Folgenummer eines Transportsblocks enthält. Diese Seiteninformation ist in Fig. 3 mit SI bezeichnet.

Falls eine sendende Seite einen negativen Bestätigungsbefehl NACK erhält, wird das Versenden von zusätzlicher inkrementeller Redundanz veranlasst. Die physikalische Schicht, die den negativen Bestätigungsbefehl (NACK) für eine oder mehrere fehlerhaft empfangene codierte Transportblöcke empfangen hat, ermittelt die RLC-Folgenummer der Paketeinheit, auf die sich die negativen Bestätigungsbefehle beziehen und teilt der zugehörigen RLC-Schicht die RLC-Folgenummern der fehlerhaften Paketeinheiten mit. Gleichzeitig speichert die empfangende physikalische Schicht die RLC-Folgenummern der als fehlerhaft gemeldeten Paketeinheiten. Die RLC-Schicht sendet dann - wie in dem Fall, bei dem sie von der gegenüberliegenden RLC-Schicht zur erneuten Sendung einer Paketeinheit aufgefordert wird (hybride ARQ-Methode Typ I) - jede dieser Paketeinheiten erneut ab. Die MAC-Schicht erzeugt aus der Paketeinheit, einen Transportblock, der dann mit der Seiteninformation an die physikalische Schicht weitergegeben wird. Die physikalische Schicht vergleicht die in der Seiteninformation enthaltene RLC-Folgenummer mit der zwischengespeicherten, und erkennt, dass dieser Transportblock als Übertragungswiederholung gesendet werden muss. Die physikalische Schicht erzeugt einen codierten Transportblock, der - nach Maßgabe der hybriden ARQ-Methode Typ II oder III - die erforderliche inkrementelle Redundanz enthält und nicht mehr die gesamte codierte Paketeinheit.

Falls die physikalische Schicht einen positiven Bestätigungsbefehl ACK erhalten hat, löscht sie die gespeicherte RLC-Folgenummer. Die physikalische Schicht kann mittels dieser RLC-Folgenummer ebenfalls der zugehörigen RLC-Schicht den korrekten Empfang der Paketeinheit bestätigen, die dann die Paketeinheit mit dieser RLC-Folgenummer aus ihrem Puffer löscht. Dies ist insbesondere im Falle der Downlink-Richtung möglich, wenn physikalische Schicht und RLC-Schicht auf der empfangenen Mobilstation nicht auf getrennten Hardware-Komponenten angesiedelt sind.. Dagegen kann es günstiger sein, dass die sendende RLC-Schicht die Empfangsmeldung von der RLC-Schicht der Empfangsseite abwartet, da immer noch Übertragungsfehler bei der Weiterleitung von der empfangenden physikalischen Schicht zur empfangenen RLC-Schicht möglich sind (insbesondere in Uplink-Richtung, da hier die empfangende physikalische Schicht und die empfangende RLC-Schicht auf verschiedenen Hardware-Komponenten untergebracht sind).

## Patentansprüche

1. Drahtloses Netzwerk mit einer Funknetzwerk-Steuerung und mehreren zugeordneten Terminals, die jeweils zum Austausch von Daten nach der hybriden ARQ-Methode vom Typ II oder III vorgesehen sind und die jeweils eine Empfangs- und/oder Sendeseite bilden, wobei
eine physikalische Schicht einer Sendeseite
- zur Speicherung von codierten Transportblöcken in einem Speicher, die wenigstens eine von der zugeordneten Funkverbindungssteuerungs-Schicht gelieferten Paketeinheit enthalten und die durch eine Paketeinheits-Folgenummer identifizierbar ist,
- zur Speicherung von Kurz-Folgenummern, deren Länge von der maximalen Anzahl von zu speichernden codierten Transportblöcken abhängt und die eindeutig auf eine Paketeinheits-Folgenummer abbildbar sind, und
- zur Übertragung von codierten Transportblöcken wenigstens mit der zugeordneten Kurz-Folgenummer vorgesehen ist und
eine physikalische Schicht einer Empfangsseite zur Prüfung des korrekten Empfangs des codierten Transportblocks und zur Sendung eines positiven Bestätigungsbefehls bei korrektem Empfang und zur Sendung eines negativen Bestätigungsbefehls zur Sendeseite bei fehlerbehafteten Empfang über einen Rückkanal vorgesehen ist.

2. Drahtloses Netzwerk nach Anspruch 1,
**dadurch gekennzeichnet,**
**dass** die Funknetzwerk-Steuerung und die zugeordneten Terminals zum Austausch von Daten nach der hybriden ARQ-Methode vom Typ II oder III vorgesehen sind.

3. Drahtloses Netzwerk nach Anspruch 1,
**dadurch gekennzeichnet,**
**dass** die physikalische Schicht einer Empfangsseite zur Sendung eines positiven oder negativen Bestätigungsbefehls mit der Kurz-Folgenummer des korrekt oder fehlerhaft empfangenen Transportblocks über den Rückkanal vorgesehen ist.

4. Drahtloses Netzwerk nach Anspruch 1,
**dadurch gekennzeichnet,**
**dass** die physikalische Schicht einer Sendeseite nach Empfang eines positiven oder negativen Bestätigungsbefehls zur Ermittlung der Kurz-Folgenummer des entsprechenden korrekt oder fehlerhaft übertragenen codierten Transportblocks anhand der Zeitdauer zwischen Übertragung des Transportblocks und Empfang des Bestätigungsbefehls und der Sendereihenfolge des Bestätigungsbefehls bei mehreren empfangenen Bestätigungsbefehlen vorgesehen ist.

5. Drahtloses Netzwerk nach Anspruch 3,
**dadurch gekennzeichnet,**
**dass** eine Übertragung der codierten Transportblöcke in Funkrahmen vorgesehen ist und dass die Übertragung eines Bestätigungsbefehls von der Sendeseite zur Empfangsseite in einem nachfolgenden Funkrahmen nach dem Funkrahmen vorgesehen ist, in dem die Übertragung des entsprechenden codierten Transportblocks endet.

6. Drahtloses Netzwerk nach Anspruch 4,
**dadurch gekennzeichnet,**
**dass** die Reihenfolge mehrerer Bestätigungsbefehle der Reihenfolge der Übertragung von letzten Teilen von Transportblöcken in einem vorhergehenden Funkrahmen entspricht.

7. Drahtloses Netzwerk nach Anspruch 1,
**dadurch gekennzeichnet,**
**dass** die physikalische Schicht einer Sendeseite nach Empfang eines positiven Bestätigungsbefehls zur Löschung des zugeordneten Transportblocks und der Kurz-Folgenummer und zur Meldung über den korrekten Empfang an die Funkverbindungssteuerungs-Schicht vorgesehen ist.

8. Drahtloses Netzwerk nach Anspruch 1,
**dadurch gekennzeichnet,**
**dass** die physikalische Schicht einer Sendeseite nach Empfang eines negativen Bestätigungsbefehls zur Sendeaufforderung einer Paketeinheit, die über den codierten Transportblock fehlerbehaftet übertragen worden ist, von der Funkverbindungssteuerungs-Schicht vorgesehen ist und
**dass** die physikalische Schicht nach Empfang einer wiederholt von der Funkverbindungssteuerungs-Schicht gesendeten Paketeinheit zur Bildung eines codierten Transportblocks vorgesehen ist, der eine inkrementelle Redundanz enthält.

9. Funknetzwerk-Steuerung in einem drahtlosen, mehrere Terminals enthaltenden Netzwerk, die zum Austausch von mit den Terminals vorgesehen ist und die eine Empfangs- und/oder Sendeseite bildet, wobei
eine physikalische Schicht der Funknetzwerk-Steuerung als Sendeseite
- zur Speicherung von codierten Transportblöcken in einem Speicher, die wenigstens eine von der zugeordneten Funkverbindungssteuerungs-Schicht gelieferten Paketeinheit enthalten und die durch eine Paketeinheits-Folgenummer identifizierbar ist,
- zur Speicherung von Kurz-Folgenummern, deren Länge von der maximalen Anzahl von zu speichernden codierten Transportblöcken abhängt und die eindeutig auf eine Paketeinheits-Folgenummer abbildbar sind, und
- zur Übertragung von codierten Transportblöcken zu einem Terminal wenigstens mit der zugeordneten Kurz-Folgenummer vorgesehen ist und
eine physikalische Schicht der Funknetzwerk-Steuerung als Empfangsseite zur Prüfung des korrekten Empfangs eines codierten Transportblocks von einem Terminal und zur Sendung eines positiven Bestätigungsbefehls bei korrektem Empfang und zur Sendung eines negativen Bestätigungsbefehls zu einem Terminal bei fehlerbehafteten Empfang über einen Rückkanal vorgesehen ist.

10. Terminal in einem drahtlosen, weitere Terminals und eine Funknetzwerk-Steuerung enthaltenden Netzwerk, das zum Austausch von mit den Terminals vorgesehen sind und das eine Empfangs- und/oder Sendeseite bildet, wobei
eine physikalische Schicht des Terminals als Sendeseite
- zur Speicherung von codierten Transportblöcken in einem Speicher, die wenigstens eine von der zugeordneten Funkverbindungssteuerungs-Schicht gelieferten Paketeinheit enthalten und die durch eine Paketeinheits-Folgenummer identifizierbar ist,
- zur Speicherung von Kurz-Folgenummern, deren Länge von der maximalen Anzahl von zu speichernden codierten Transportblöcken abhängt und die eindeutig auf eine Paketeinheits-Folgenummer abbildbar sind, und
- zur Übertragung von codierten Transportblöcken zu der Funknetzwerk-Steuerung wenigstens mit der zugeordneten Kurz-Folgenummer vorgesehen ist und
eine physikalische Schicht des Terminals als Empfangsseite zur Prüfung des korrekten Empfangs eines codierten Transportblocks von der Funknetzwerk-Steuerung und zur Sendung eines positiven Bestätigungsbefehls bei korrektem Empfang und zur Sendung eines negativen Bestätigungsbefehls zu der Funknetzwerk-Steuerung bei fehlerbehafteten Empfang über einen Rückkanal vorgesehen ist.
